# EUROPEAN PATENT APPLICATION

(11) **EP 4 579 392 A1**
(43) Date of publication of application: **02.07.2025**
(21) Application number: 24799833.9
(22) Date of filing: 28.02.2024
(51) Int. Cl.: G06F 1/20, G06F 1/18

(54) **IMMERSED LIQUID COOLED SERVER**

(30) Priority: 04.05.2023 CN 202310490789
(71) Applicant: Suzhou Metabrain Intelligent Technology Co., Ltd., Suzhou, Jiangsu 215000 (CN)
(72) Inventor: YANG, Jie, Suzhou, Jiangsu 215000 (CN); YIN, Xiuzhong, Suzhou, Jiangsu 215000 (CN); LI, Changchang, Suzhou, Jiangsu 215000 (CN); LIU, Tingwei, Suzhou, Jiangsu 215000 (CN); FU, Jiangkun, Suzhou, Jiangsu 215000 (CN)
(74) Representative: Studio Torta S.p.A.
(86) International application number: PCT/CN2024/079092
(87) International publication number: WO 2024/227375

(57) **Abstract**

The present invention provide an immersed liquid cooled server, including: a chassis provided with a first end and a second end opposite to the first end, when the chassis is immersed in a water tank, the first end is located on an opening side of the water tank, the chassis is provided with a first region and a second region, and when the chassis is taken out of the water tank and placed horizontally, the first region and the second region are separated and stacked vertically; a basic component for maintaining an operation of the server, the basic component is located in the first region, at least a portion of the basic component is detachably arranged at the first end, and exposed from the chassis; a mounting bracket movably arranged in the second region of the chassis and being able to extend out of the chassis from the first end, the mounting bracket is provided with a mounting position for mounting an expansion component. The present invention solves the problem in the related art that an inspection and maintenance of an immersion server are time-consuming and inefficient.

## Description

### Cross-Reference to Related Application

The present invention claims priority and the benefit of Chinese Patent Application No. 202310490789.2, filed with the China National Intellectual Property Administration (CNIPA) on 04 May 2023, and entitled "Immersed Liquid Cooled Server", which is herein incorporated by reference in its entirety.

### Technical Field

The present invention relates to the technical field of servers, and in particular to an immersed liquid cooled server.

### Background

With the continuous increase in power consumption of key components such as server processors and PCIE devices, air-cooling technology is becoming increasingly inadequate to address system cooling issues, and furthermore, driven by the need to reduce energy consumption and lower the PUE of data centers, server design is beginning to shift towards immersion liquid cooling solutions.

Immersion liquid cooling specifically involves immersing servers in horizontal chassis (i.e. Tank), where the convective flow of a fluorinated liquid within the Tank effectively dissipates heat from the servers. Such immersion servers are typically mounted into the Tank from top to bottom using lifting device, when inspection and repairing within the server is required, the existing schemes mostly necessitate the removal of the immersion server from the Tank, and this process involves the use of lifting device to lift the entire server out and place it on a platform, after which inspection, repairing and component replacement operations is able to be carried out. The entire inspection and repairing process is cumbersome, time-consuming, labor-intensive, and inefficient.

### Summary

The present invention provides an immersed liquid cooled server, so as to at least solve the problem in the related art that an inspection and maintenance of an immersion server is time-consuming and inefficient.

Some embodiments of the present invention provide an immersed liquid cooled server, including: a chassis, the chassis is provided with a first end and a second end opposite to the first end, when the chassis is immersed in a water tank, the first end is located at an opening side of the water tank, the chassis is provided with a first region and a second region, and when the chassis is taken out of the water tank and placed horizontally, the first region and the second region are separated and stacked vertically; a basic component for maintaining an operation of the server, the basic component is located in the first region, and at least a portion of the basic component is detachably arranged at the first end, and exposed from the chassis, the basic component includes a main board, a network card, an interface and a hard disk; and a mounting bracket, the mounting bracket is movably arranged in the second region of the chassis and is able to extend out of the chassis from the first end, the mounting bracket is provided with a mounting position for mounting an expansion component.

In some embodiments, the interface includes an Input/Output (IO) interface; the hard disk includes a hot-plug hard disk; the basic component further includes an Open Compute Project (OCP) network card; and the network card, the IO interface, the OCP network card and the hot-plug hard disk are detachably arranged at the first end, and are exposed from the chassis.

In some embodiments, the expansion component includes at least one of an expansion hard disk and a Graphics Processing Unit (GPU).

In some embodiments, the immersed liquid cooled server further includes a backplane, the backplane is located at the second end, one side of the backplane is provided with a connector for connecting to components in the first region, and the other side of the backplane is provided with an expansion interface for connecting to components in the second region.

In some embodiments, the immersed liquid cooled server further includes a power supply clamp, the power supply clamp is arranged in the chassis and is located at the second end, and when the chassis is immersed in the water tank, the power supply clamp contacts a contact at a bottom of the water tank, and an external power supply supplies power to the immersed liquid cooled server.

In some embodiments, the immersed liquid cooled server further includes a space-occupying and flow-guidance block, the space-occupying and flow-guidance block is arranged in the chassis and located at the second end, and the space-occupying and flow-guidance block is provided with a channel for guiding a coolant.

In some embodiments, one or more mounting brackets are provided, and when a plurality of mounting brackets are provided, the mounting brackets are arranged along a length direction of the first end.

In some embodiments, the plurality of mounting brackets are provided, and all of the plurality of mounting brackets include at least one of a hard disk bracket and a Graphics Processing Unit (GPU) bracket.

In some embodiments, the mounting bracket includes a hard disk bracket, and the hard disk bracket includes: a first bracket body, the first bracket body is provided with a mounting region, the first bracket body is movably connected to the chassis and s able to extend from the first end; and a hard disk rack, the hard disk rack is arranged in the mounting region, the hard disk rack is provided with the mounting position for mounting an expansion hard disk, and when the first bracket body extends from the chassis, the hard disk rack is exposed from the chassis.

In some embodiments, a plurality of hard disk racks are provided, and at least a portion of the hard disk racks are arranged along a direction in which the first bracket body extends from the chassis.

In some embodiments, the hard disk rack is provided with a first side and a second side that are arranged opposite to each other; the first side is closer to the first end than the second side; the second side of at least one of the plurality of hard disk brackets is rotatably connected to the first bracket body; and when the first bracket body extends from the chassis, the hard disk rack s able to rotate and lift the first side by a predetermined distance.

In some embodiments, the hard disk bracket further includes a handle, the handle is rotatably arranged on an side, between the first side and the second side, of the hard disk bracket, and when the handle rotates, an end of the handle abuts against the first bracket body, and supports the hard disk bracket to be in an inclined state.

In some embodiments, the hard disk bracket further includes: a fixing frame, the fixing frame is arranged in the mounting region and located on a peripheral side of the hard disk rack; and a first liquid-occupying block, the fixing frame is provided with a cavity, the first liquid-occupying block is arranged in the cavity, and the first liquid-occupying block and the fixing frame are snap-fitted with each other; and/or a the fixing frame and the first bracket body are snap-fitted with each other.

In some embodiments, the mounting bracket includes a GPU bracket, and the GPU bracket comprises a second bracket body, the second bracket body is movably connected to the chassis and is able to extend out from the first end; the second bracket body is provided with the mounting position for mounting a GPU; one or more mounting positions are provided; and when a plurality of mounting positions are provided, at least a portion of the mounting positions are arranged along a direction in which the second bracket body extends from the chassis.

In some embodiments, wherein the plurality of mounting positions are provided, and along an axis of the second bracket body, at least two of the plurality of mounting positions are located on two sides of the axis of the second bracket body.

In some embodiments, the plurality of mounting positions are sequentially and alternately located on two sides of the axis of the second bracket body.

In some embodiments, the GPU bracket further includes a second liquid-occupying block, the second liquid-occupying block is located on the second bracket body and is arranged opposite to the mounting position, so that the GPU mounted on the mounting position and the oppositely arranged second liquid-occupying block cover a width of the second bracket body.

In some embodiments, an end, located at the first end, of the mounting bracket is provided with an operating handle for pulling out the mounting bracket.

In some embodiments, the immersed liquid cooled server further includes: a slide rail for fitting with a slide way of an inner wall of the water tank, the slide rail is arranged on an outer side surface of the chassis; and a lifting handle, the lifting handle is located on an outer side surface of the first end of the chassis, the lifting handle is provided with a snap for fitting with a snap position of an inner wall of the water tank, and when the chassis is immersed in the water tank, the snap is snap-fitted with the snap position.

In some embodiments, the lifting handle includes: a lifting ring, the lifting ring is provided with a mounting groove; a pull ring, the pull ring is movably arranged relative to the lifting ring, at least a portion of the pull ring is located in the mounting groove; and a snap member, the snap member is located in the mounting groove and rotatably connected to the lifting ring, wherein the snap member is provided with the snap being able to extend out of the mounting groove; the snap member is provided with a drive groove; the pull ring is provided with a drive arm; the drive arm is located in the drive groove; and when the pull ring moves, the drive arm presses against the inner wall of the drive groove, and drives the snap member to rotate, so that the snap retracts into the mounting groove.

In some embodiments, the lifting handle further includes: a snap reset member, the snap reset member is arranged in the mounting groove and abuts against the snap member, the snap reset member provides a reset force for the snap member to extend out of the mounting groove; and a pull-ring reset member, the pull-ring reset member is arranged in the mounting groove and abuts against the pull ring, the pull-ring reset member provides a reset force for the pull ring in an opposite direction of a movement that retracts the snap into the mounting groove.

In some embodiments, the network card, the interface, and the hard disk are exposed from the chassis, and a personnel is able to directly perform inspection and maintenance on the components of the first end through the opening side.

In the technical solution of the present invention, most of the components of the server are arranged at the first end of the chassis, since the first end is close to the opening side of the water tank, maintenance personnel is able to conveniently inspect and maintain the components located at the first end of the chassis from the opening side of the water tank, in this way, there is no need to hoist the entire server out of the water tank, significantly reducing the difficulty and complexity of maintenance, and decreasing the frequency of using lifting device to lift the entire server out of the water tank, thereby simplifying the maintenance process. Furthermore, with regard to the difference between the basic component and the expansion component, an arrangement manner with upper and lower layers is adopted, dividing the space into the first region and the second region; since the basic components are necessary components, and are necessarily arranged on the server, the basic components only need to be normally arranged at the first end of the first region, during inspection, the plug-and-play basic components are able to be simply unplugged for inspection; while the requirements and types of expansion components are vary, accordingly, in order to maintain the expansion components, the present invention further provides a mounting bracket, and the mounting bracket is arranged in the second region of the lower layer, and is able to extend from the first end, so that maintenance personnel is able to pull out the mounting bracket when inspecting the expansion component, which brings the expansion components along with it, allowing for convenient inspection and replacement of the expansion components, so as to satisfy different usage needs. This arrangement manner enables the server not to be hoisted from the water tank in most maintenance scenarios, and only the first end of the chassis needs to be maintained, thereby greatly facilitating maintenance of various components in the server, reducing maintenance difficulties, and improving maintenance efficiency.

### Brief Description of the Drawings

Fig. 1 is a schematic structural diagram of an immersed liquid cooled server being placed in a water tank according to the present invention;
Fig. 2 is a schematic structural diagram of the immersed liquid cooled server of Fig. 1 being hoisted and placed horizontally;
Fig. 3 is a schematic structural diagram of a rear view of Fig. 2;
Fig. 4 is a schematic structural diagram of Fig. 2 with a portion of the chassis removed;
Fig. 5 is an exploded view of some of the components of Fig. 2;
Fig. 6 is a structural schematic diagram of a backplane;
Fig. 7 is a schematic structural diagram from another view of the backplane of Fig. 6;
Fig. 8 is a schematic structural diagram of an immersed liquid cooled server when a mounting bracket is a hard disk bracket;
Fig. 9 is a schematic structural diagram of a hard disk bracket;
Fig. 10 is a schematic structural diagram of a single hard disk bracket;
Fig. 11 is a structural schematic diagram of a hard disk rack of a hard disk bracket rotating upwards;
Fig. 12 is an enlarged view of the hard disk rack of Fig. 11;
Fig. 13 is a schematic structural diagram of a fixing frame fitting with a first liquid-occupying block in Fig. 12;
Fig. 14 is a schematic structural diagram of an immersed liquid cooled server when a mounting bracket is a GPU bracket;
Fig. 15 is a schematic structural diagram of a GPU bracket;
Fig. 16 is a schematic structural diagram of a single GPU bracket;
Fig. 17 is an exploded view of a lifting handle;
Fig. 18 is a structural schematic diagram of a lifting handle with the snap extended;
Fig. 19 is a structural schematic diagram of a lifting handle with the snap retracted.

The drawings include the following reference signs:
10. chassis; 20: basic component; 21: main board; 22: network card; 23: IO interface; 24: OCP network card; 25: hot-plug hard disk; 30: mounting bracket; 31: hard disk bracket; 311: first bracket body; 312: hard disk rack; 313: handle; 314: fixing frame; 315: first liquid-occupying block; 32: GPU bracket; 321, second bracket body; 322: second liquid-occupying block; 33: operating handle; 41: expansion hard disk; 42: GPU; 50: backplane; 60: power supply clamp; 70: space-occupying and flow-guidance block; 80: slide rail; 90: lifting handle; 91: lifting ring; 911: mounting groove; 92: pull ring; 921: drive arm; 93: snap member; 931: snap; 932: drive groove; 94: snap reset member; 95: pull-ring reset member; 100: water tank; 101: slide way; 102: snap position.

### Detailed Description of the Embodiments

The embodiments of the present invention are described in detail with reference to the accompanying drawings and in conjunction with the embodiments.

It should be noted that the embodiments in the disclosure and features in the embodiments can be combined without conflicts. The disclosure will be described below in detail with reference to the drawings and in combination with the embodiments.

It is to be noted that unless otherwise indicated, all technical and scientific terms used in the present invention have the same meanings as those commonly understood by one of ordinary skill in the art to which the present invention belongs.

In the present invention, unless specified to the contrary, the directional terms such as "upper, lower, top, and bottom" are generally used regarding the directions shown in the figures, or for the components themselves in vertical, perpendicular, or gravity directions; likewise, for ease of understanding and description, "internal, external" refer to internal and external relative to the outline of each component itself, but the described directional terms are not used to limit the present invention.

In order to solve the problem in the related art that an inspection and maintenance of an immersion server is time-consuming and inefficient, the present invention provides an immersed liquid cooled server.

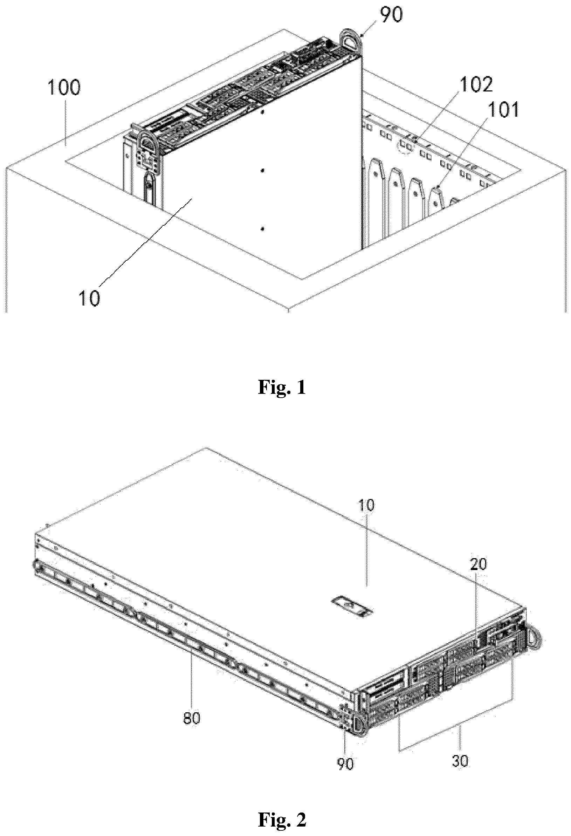

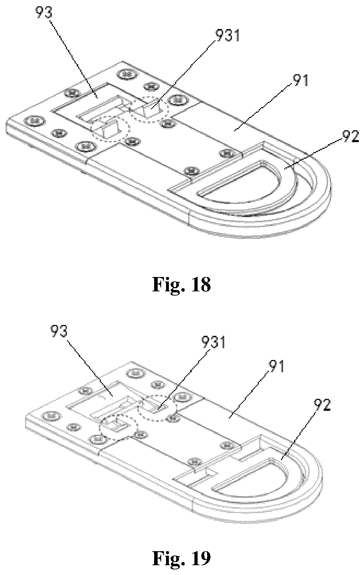

An immersed liquid cooled server as shown in Figs. 1-19 includes a chassis 10, a basic component 20 for maintaining an operation of the server, and a mounting bracket 30, the chassis 10 is provided with a first end and a second end opposite to the first end, when the chassis 10 is immersed in a water tank 100, the first end is located on an opening side of the water tank 100, the chassis 10 is provided with a first region and a second region, and when the chassis 10 is taken out of the water tank 100 and placed horizontally, the first region and the second region are separated and stacked vertically; the basic component 20 is located in the first region, at least a portion of the basic component 20 is detachably arranged at the first end and exposed from the chassis 10, and the basic component 20 includes a main board 21, a network card 22, an interface and a hard disk; and the mounting bracket 30 is movably arranged in the second region of the chassis 10 and is able to extend out of the chassis 10 from the first end, and the mounting bracket 30 is provided with a mounting position for mounting an expansion component.

In the embodiment, most of the components of the server are arranged at the first end of the chassis 10, since the first end is close to the opening side of the water tank 100, maintenance personnel is able to conveniently inspect and maintain the components located at the first end of the chassis 10 from the opening side of the water tank 100, in this way, there is no need to hoist the entire server out of the water tank 100, significantly reducing the difficulty and complexity of maintenance, and decreasing the frequency of using lifting device to lift the entire server out of the water tank 100, thereby simplifying the maintenance process. Furthermore, with regard to the difference between the basic component 20 and the expansion component, an arrangement manner with upper and lower layers is adopted, dividing the space into the first region and the second region; since the basic components 20 are necessary components, and are necessarily arranged on the server, the basic components 20 only need to be normally arranged at the first end of the first region, during inspection, the plug-and-play basic components 20 is able to be simply unplugged for inspection; while the requirements and types of expansion components are vary, accordingly, in order to maintain the expansion components, in the embodiment, a mounting bracket 30 is further provided, and the mounting bracket 30 is arranged in the second region of the lower layer, and is able to extend from the first end, so that maintenance personnel is able to pull out the mounting bracket 30 when inspecting the expansion component, which brings the expansion components along with it, allowing for convenient inspection and replacement of the expansion components, so as to meet different usage needs. This arrangement manner enables the server not to be hoisted from the water tank 100 in most maintenance scenarios, and only the first end of the chassis 10 needs to be maintained, thereby greatly facilitating maintenance of various components in the server, reducing maintenance difficulties, and improving maintenance efficiency.

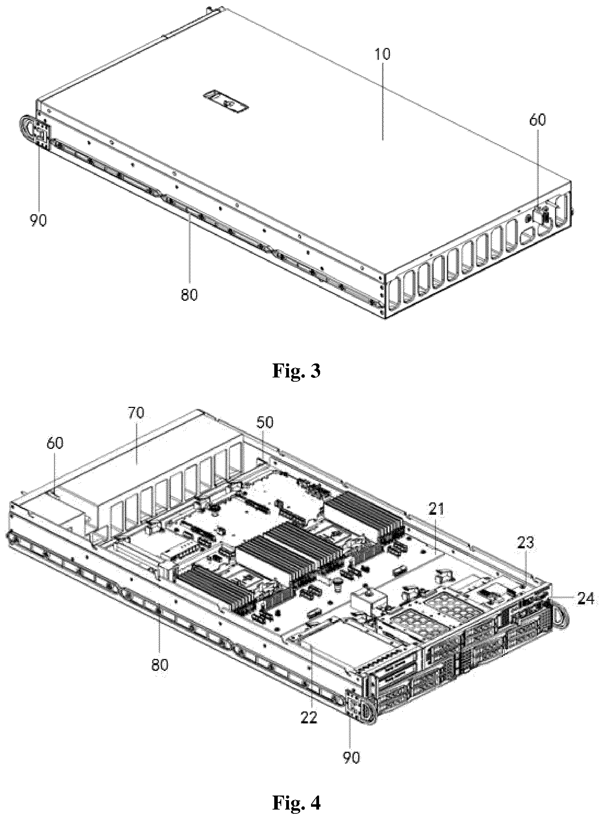

As shown in Figs. 4-5, in the embodiment, the interface includes an Input/Output (IO) interface 23; the hard disk includes a hot-plug hard disk 25; the basic component 20 further includes an Open Compute Project (OCP) network card 24, that is to say, the basic component 20 for maintaining the operation of a server includes a main board 21, a network card 22, an IO interface 23, i.e. an input/output interface, the OCP network card 24 and the hot-plug hard disk 25; components such as the main board 21 and parts thereon do not need to be frequently replaced and maintained are able to be arranged in the chassis 10, and are not necessarily located at the first end, while components such as the network card 22, the IO interface 23, the OCP network card 24 and the hot-plug hard disk 25 that need to be frequently maintained are detachably arranged at the first end, and are exposed from the chassis 10, in this way, maintenance personnel is able to conveniently maintain these frequently maintained components from the first end of the chassis 10, thereby further reducing the frequency of lifting the immersion server. Meanwhile, components such as the network card 22, the IO interface 23, the OCP network card 24, and the hot-plug hard disk 25 may be connected to the main board 21 by means of wires, and the specific connection mode is not further described.

It should be noted that the basic component 20 mentioned above is not limited to the specific component described, and may vary depending on factors such as the type of server; and the basic component is able to be adjusted as needed, as long as the frequently maintained components are arranged at the first end for convenient maintenance.

In an embodiment, the expansion component commonly used in the current server includes at least one of an expansion hard disk 41 and a GPU 42. The specific expansion component may be selectively configured as required such as different service scenarios. In a scenario requiring large-capacity storage, an expansion hard disk 41 is able to be selected as an expansion component; and in a scenario requiring accelerated Al calculation, the GPU 42, i.e. a graphics processor unit, is able to be selected as an expansion component, or the expansion hard disk 41 and the GPU 42 may be arranged at the same time to achieve expansion of the two aspects. It should be noted that the expansion component may also use other components in addition to the expansion hard disk 41 and the GPU 42 listed above.

In the embodiment, when being placed in the water bank 100 and when being hoisted vertically for placement, the chassis 10 is in two states respectively; when being placed in the water bank 100, the chassis 10 is in a vertically placed state, as shown in Fig. 1, and the chassis has a high height and a rectangular horizontal section, the rectangle includes a long side and a short side; while when being hoisted for placement, the chassis 10 is generally placed horizontally, as shown in Fig. 2, in this case, the chassis 10 has a long length, the length corresponds to the foregoing height, and the height of the chassis 10 corresponds to the length of the short side of the foregoing rectangle, in this case, the width of the chassis 10 corresponds to the length of the long side of the foregoing rectangle.

Based on the two different states, the first region and the second region in the embodiment are in different states according to the chassis 10, and the specific ranges of the first region and the second region are as follows: when the chassis 10 is immersed in the water tank 100, the first region and the second region are arranged transversely along the width direction of the chassis 10, that is, along the left and right sides of the short-side direction of the rectangular cross-section; when the chassis 10 is hoisted and placed horizontally, the first region and the second region are arranged vertically, i.e. along the height of the chassis 10, and in this case, the first region is located above the second region, as shown in Fig. 2. The basic component 20 is located in the first region, the expansion component is located in the second region, and the first region and the second region are separated by a partition plate in the middle of the chassis 10. In this way, the basic component 20 is separated from the expansion component, so that maintenance personnel are more clearly aware of the distribution of the components on the chassis 10, so as to facilitate recognition and maintenance, and also facilitate the arrangement of a plurality of expansion components.

In another embodiment, the base component 20 and the expansion component may also be arranged in a staggered manner, and each component is arranged at a corresponding position according to factors such as ease of mounting.

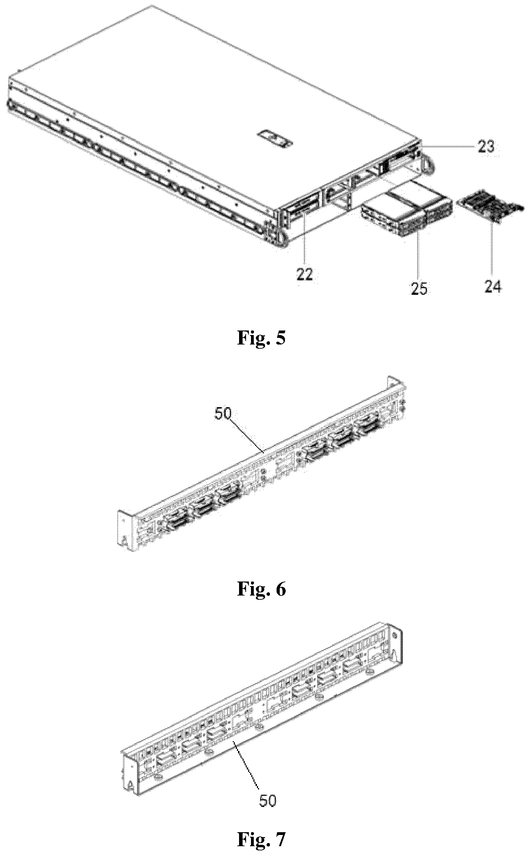

As shown in Figs. 6-7, in the embodiment, the immersed liquid cooled server further includes a backplane 50, the backplane 50 is located at the second end; based on the foregoing region division arrangement between the first region and the second region, in the embodiment, a connector for connecting to components in the first region is arranged on one side of the backplane 50, the connector is locked and attached to a backplane bracket, and the other side of the backplane 50 is provided with an expansion interface for connecting to components in the second region. In this way, two sides of the backplane 50 are respectively connected to the components in the first region and the components in the second region, i.e. on the structure, an side, close to the second end, of the main board 21 is connected to the backplane 50, and the expansion hard disk 41 and the GPU 42 share the other side of the backplane 50; in signal transmission, one end of the backplane 50 is connected to the expansion component at the lower layer, and the other end is directly connected to a signal connector on the main board 21 by means of a cable. In this way, it not only facilitates connections but also reduces intermediate transfer links, thereby minimizing signal loss.

The number of the backplanes 50 is able to be set according to needs, and one or more backplanes may be provided. When a plurality of mounting brackets 30 are provided, a plurality of backplanes 50 may also be provided, and are able to be in one-to-one correspondence with the mounting brackets 30. In an embodiment, only one backplane 50 may be provided, and the plurality of mounting brackets 30 share one backplane 50. The connector is able to be in a floating design, thereby effectively avoiding an assembly error caused by assembly tolerances, and ensuring the assembly reliability of a component node and the backplane 50.

As shown in Fig. 3, in the embodiment, the immersed liquid cooled server further includes a power supply clamp 60; the power supply clamp 60 is arranged in the chassis 10 and located at the second end; the power supply clamp 60 is able to be fitted with a copper bar at a bottom of the water tank 100, and when the chassis 10 is immersed in the water tank 100, the power supply clamp 60 is in contact with the contactors of the copper bar at the bottom of the water tank 100; and the power supply clamp 60 is then connected to a power supply connector on the main board 21 by means of an internal cable. In this way, the external power supply is able to supply power to the server, and it is unnecessary to separately provide a power supply in the server, thereby realizing external power supply of the server.

As shown in Fig. 4, in the embodiment, the immersed liquid cooled server further includes a space-occupying and flow-guidance block 70, and the space-occupying and flow-guidance block 70 is arranged in the chassis 10 and located at the second end. The space-occupying and flow-guidance block 70 is made of foamed polypropylene material, which is lightweight and corrosion-resistant. The space-occupying and flow-guidance block 70 serves two purposes. First, the fluorinated liquid commonly used as a coolant in the water tank 100 is expensive, since the interior of the chassis 10 has a significant amount of space not occupied by components, this leads to a large amount of vacant space within the chassis 10, and these vacant space also requires a fluorinated liquid to fill, increasing the overall usage of the fluorinated liquid; however, after the space-occupying and flow-guidance block 70 is provided, the space-occupying and flow-guidance block 70 is able to occupy a part of the unused space, so that the amount of the fluorinated liquid required to be filled in the chassis 10 is reduced, and thus the usage of fluorinated liquid is reduced, thereby reducing cost. The reason for placing the space-occupying and flow-guidance block 70 at the second end is that the first end is mounted with a large number of basic components 20, leaving little unused space, and the middle portion of the chassis 10 contains the main board 21 and components integrated thereon, also leaving limited unused space; in contrast, the second end is mainly provided with the power supply clamp 60, with a significant amount of space remaining unused, and thus, the space-occupying and flow-guidance block 70 is provided there; certainly, the space-occupying and flow-guidance block 70 is also able to be mounted in other positions as needed to further reduce the usage amount of fluorinated liquid. Secondly, the space-occupying and flow-guidance block 70 has a guiding function, the space-occupying and flow-guidance block 70 has a channel for guiding a coolant, an opening of the channel faces components such as the main board 21, and the fluorinated liquid may flow along the channel to components, such as the main board 21, requiring heat dissipation, thereby improving the heat dissipation effect.

In the embodiment, the space-occupying and flow-guidance block 70 is secured by wrapping it with a plastic member, thereby simplifying simplifies the appearance thereof, facilitating the reduction of the variety of the positioning and flow-guidance block 70, and lowering the difficulty of mold forming of the positioning and flow-guidance block 70. The subsequent first liquid-occupying block 315 and second liquid-occupying block 322 may also be arranged in such a manner.

In an embodiment, the number of the mounting brackets 30 can be set as required, one or more mounting brackets may be provided, and in the embodiment, two mounting brackets 30 are provided as an example. As mentioned above, when the plurality of mounting brackets 30 are provided, each of the plurality of mounting brackets 30 is able to be fitted with the same type of expansion components or is able to be fitted with different types of expansion components. In an embodiment, the plurality of mounting brackets 30 are arranged in the length direction of the first end, i.e. arranged in the length direction of the long side of the rectangular cross-section, so that the arrangement direction between the plurality of mounting brackets 30 is arranged perpendicular to the arrangement direction between the first region and the second region, thereby making full use of the space of the second region, increasing the number of components that is able to be arranged at the first end, and ensuring the effect of convenient maintenance. Certainly, the mounting brackets 30 may also be arranged in the arrangement direction between the first region and the second region, or the described two arrangements may be used simultaneously.

On the basis of the difference of the expansion components fitted with the mounting bracket 30, the mounting bracket 30 may include at least one of the hard disk bracket 31 and the GPU bracket 32. The specific arrangements of different mounting brackets 30 are also different, so as to ensure that the mounting bracket 30 is able to be reliably fitted with the corresponding expansion component.

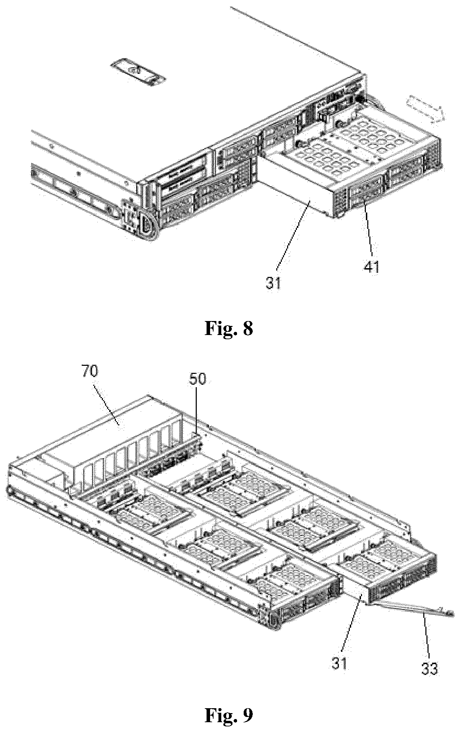

As shown in Figs. 8-12, the mounting bracket 30 in the embodiment includes a hard disk bracket 31; the hard disk bracket 31 includes a first bracket body 311 and a hard disk bracket 312; the first bracket body 311 is drawer-shaped and forms a mounting region; the first bracket body 311 is movably connected to the chassis 10, and is able to extend out from the first end to form a structural form similar to a drawer, and is able to be conveniently pulled out when requiring maintenance; a side, facing the second end, of the first bracket body 311 is able to fit with the backplane 50; and the expansion hard disk 41 on the first bracket body 311 is able to be connected to the backplane 50 by means of components such as a wire and a connector. The hard disk rack 312 is arranged in the mounting region, and the hard disk rack 312 is provided with a mounting position for mounting the expansion hard disk 41, thereby implementing the mounting and fixation of the expansion hard disk 41. When the first bracket body 311 extends from the chassis 10 under the action of an external force, the mounting bracket 30 moves along with the first bracket body 311, so that the internal hard disk bracket 312 and the expansion hard disk 41 thereon are exposed from the chassis 10, thereby realizing inspection and replacement of the expansion hard disk 41.

Considering that the length of the first bracket body 311 is able to be set to be long, the size of the mounting region thereof is relatively large, providing a large amount of space available, and thus a plurality of hard disk racks 312 are able to be provided, the plurality of hard disk racks 312 re able to be arranged in the first bracket body 311 as required, and each hard disk rack 312 is provided with one or more independent mounting positions, thereby achieving an effect that a plurality of expansion hard disks 41 are able to be mounted on one hard disk bracket 31.

As the first bracket body 311 has a relatively long length along the height direction of the vertically placed chassis 10, in the embodiment, at least a portion of the plurality of hard disk racks 312 are arranged in a direction in which the first bracket body 311 extends from the chassis 10, that is, in a length extension direction of the first bracket body 311, which allows for full utilization of the space within the first bracket body 311, thereby improving space utilization rate. Certainly, a portion of the plurality of hard disk racks 312 may also be arranged in a direction perpendicular to the direction in which the first bracket body 311 extends from the chassis 10, that is, arranged along a length direction of a long side of a rectangular cross section of the chassis 10, or the two arrangement manners may be simultaneously used, as long as the mounting of the hard disk racks 312 is able to be implemented.

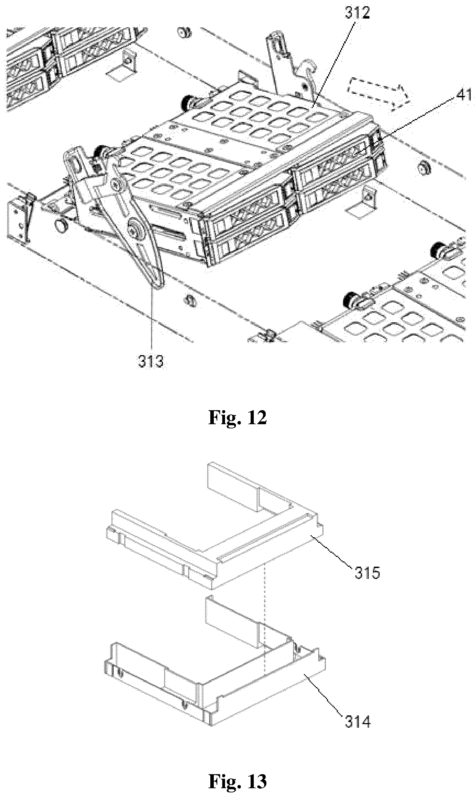

In the embodiment, the hard disk rack 312 is provided with a first side and a second side provided opposite to each other; the first side is parallel to the edge of the first end; the second side is parallel to the edge of the second end edge; the first side is a socket side of the hard disk rack 312 for insertion of the expansion hard disk 41; and the first side is closer to the first end than the second side, that is, the first side is closer to the opening side of the water tank 100 than the second side. In the embodiment, the hard disk rack 312 is rotatably connected to the first bracket body 311, and more specifically, the second side of the hard disk rack 312 is rotatably connected to the first bracket body 311, in this way, when the first bracket body 311 extends from the chassis 10, the maintenance personnel is able to rotate the hard disk rack 312, causing the first side to rise by a predetermined distance, thereby lifting the first side of the hard disk rack 312, wherein lifting herein is described with respect to the chassis 10 in a horizontally placement state, as shown in Fig. 12, the first side is staggered from the adjacent hard disk rack 312, allowing maintenance personnel to take out the expansion hard disk 41 in the hard disk rack 312 the from the socket on the first side for inspection and replacement. The described arrangement not only enables the expansion hard disk 41 to be removable and replaceable but also allows for a smaller gap between the hard disk racks 312; if the above arrangement is not used, a larger distance needs to be reserved between the hard disk racks 312 to remove the expansion hard disk 41 from within the hard disk rack 312; the described arrangement in the embodiment is able to effectively increase the arrangement density between the hard disk racks 312, and increase the space utilization of the mounting region, in this way, a larger number of hard disk racks 312 may be arranged in the first bracket body 311, thereby meeting the quantity demand for hard disk expansion.

In an embodiment, the hard disk rack 312 is arranged in a movable manner, the entire hard disk rack 312 is able to be moved to change its positional shielding relationship with an adjacent hard disk rack 312, allowing the hard disk rack 312 to move to a position where the socket is not shielded by another hard disk rack 312, thereby realizing plugging and unplugging of the expansion hard disk 41.

In the embodiment, the hard disk bracket 31 further includes a handle 313; the handle 313 has a certain length; the handle 313 is rotatably arranged on a side, between the first side and the second side, of the hard disk rack 312; in this way, when the hard disk rack 312 needs to be rotated, the maintenance personnel rotates by means of the operating handle 33; during the rotation of to the handle 313, one end of the handle 313 is gradually close to the inner bottom surface of the first bracket body 311 and abuts against the first bracket body 311, and then, the handle 313 continues to rotate, and as one end of the handle 313 abuts against the first bracket body 311, the connection between the handle 313 and the hard disk rack 312 rises relative to the inner bottom surface of the first bracket body 311, and thus, the hard disk rack 312 rotates around the connection shaft between the hard disk rack 312 and the first bracket body 311, so that the first side of the hard disk rack 312 is lifted, causing the hard disk rack 312 to be inclined, and the expansion hard disk 41 is able to be taken out. When the handle 313 is rotated in place, the handle 313 is held in the position, and in this case, the handle 313 is held against the first bracket body 311, so that the hard disk rack 312 is held in an inclined state by means of the support of the handle 313, thereby facilitating the maintenance personnel to operate the expansion hard disk 41.

In an embodiment, the number of the handle 313 is able to be set as required, and the handle 313 is arranged on only one side of the hard disk rack 312, or the handle 313 is arranged on two opposite sides of the hard disk rack 312, so as to ensure that the hard disk rack 312 is in a stable position.

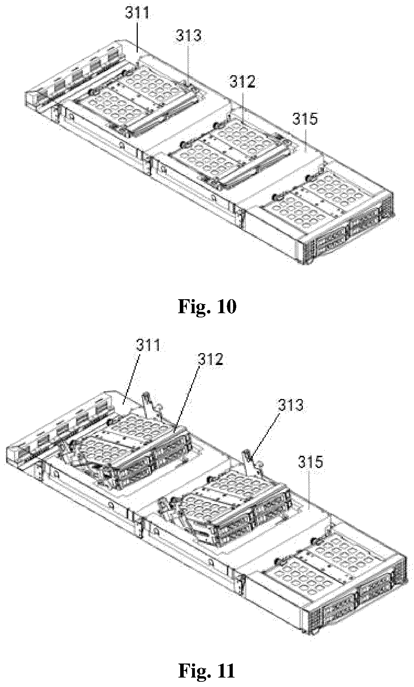

It should be noted that, a portion of the plurality of hard disk racks 312 are arranged in a direction in which the first bracket body 311 extends from the chassis 10; for the hard disk racks 312 at the end portion of the first end, the side surface of the chassis 10 is provided with a through hole for plugging and unplugging of the expansion hard disk 41, the socket of the hard disk rack 312 is in communication with the through hole, and therefore, the rotatable arrangement manner for these hard disk racks 312 is unnecessary; on this basis, the hard disk racks 312 at the end portion of the first end may be arranged in a fixed manner, and the hard disk racks 312 at other positions may be arranged in a rotatable manner, so that the hard disk rack 312 to be adapted to the mounting position, as shown in Fig. 11.

In an embodiment, a latch structure may be arranged on the handle 313, and the latch structure may be fitted with a locking position on the first bracket body 311, so that the handle 313 locks a position by means of the latch structure, thereby preventing random rotation of the hard disk rack 312, and ensuring safety and stability during use. During maintenance, the latch structure is unlocked first, so that the handle 313 is unlocked, and then the handle 313 is able to be rotated, so as to rotate the hard disk rack 312, thereby achieving the maintenance of the expansion hard disk 41.

In the embodiment, the hard disk bracket 31 further includes a fixing frame 314 and a first liquid-occupying block 315; the fixing frame 314 is arranged in the mounting region and located on a peripheral side of the hard disk rack 312; the fixing frame 314 is provided with a cavity, and the first flow-guidance block 315 is arranged in the cavity; similar to the space-occupying and flow-guidance block 70, the first flow-guidance block 315 is also made of a foamed polypropylene material, and has the advantages of light weight and corrosion resistance, and the effects of the two are basically the same; in this way, the mounting of the first flow-guidance block 315 is realized by the fixing frame 314, and the first flow-guidance block 315 is able to realize the occupation of space and the diversion of coolant, thereby reducing the usage amount of the coolant, lowering the cost, and ensuring that the coolant flows to components that generates heat, to improve the heat dissipation effect.

As shown in Fig. 13, the fixing frame 314 of the embodiment adopts a square C-shaped structure; the middle portion of the square C-shaped structure is able to be used to accommodate the hard disk rack 312, while the edge of the square C-shaped structure a double-layered structure; the double-layered structure naturally creates a cavity, allowing the first liquid-occupying block 315 to be mounted in the cavity. Considering that there are the plurality of hard disk racks 312, a plurality of fixing frames 314 and a plurality of first flow-guidance blocks 315 may be provided, and the plurality of fixing frames 314, the plurality of first flow-guidance blocks 315 and the plurality of hard disk racks 312 may correspond and cooperate with each other in one-to-one correspondence, thereby providing liquid occupying and flow guidance around the peripheral side of each hard disk rack 312. Certainly, the fixing frame 314 may also adopt other structural forms, for example, adopting a ring structure, and the corresponding arrangement relationship between the fixing frame 314, the first liquid-occupying block 315, and the hard disk rack 312 may also be adjusted as required, as long as the functions of liquid occupying and flow guidance are able to be implemented.

The first liquid-occupying block 315 and the fixing frame 314 are snap-fitted with each other or the fixing frame 314 and the first bracket body 311 are snap-fitted with each other, or the first liquid-occupying block 315 and the fixing frame 314 are snap-fitted with each other and the fixing frame 314 and the first bracket body 311 are snap-fitted with each other. In the embodiment, the first liquid-occupying block 315 and the fixing frame 314 are snap-fitted with each other and the fixing frame 314 and the first bracket body 311 are snap-fitted with each other, so that tool-free assembly and disassembly can be achieved, and assembly is facilitated. Specifically, in the embodiment, a snap structure is provided between the fixing frame 314 and the first flow-guidance block 315, likewise, the snap structure is also provided between the fixing frame 314 and the first bracket body 311, in this way, during mounting, the fixing frame 314 is snap-fitted on the first bracket body 311, and the first liquid-occupying block 315 is snap-fitted on the fixing frame 314, thus, the fixing frame 314 and the first flow-guidance block 315 are mounted and fixed in the mounting region.

In an embodiment, the specific form of the snap structure is able to be adjusted as required, for example, providing a common snap and a common snap position, or providing a slide way snap, etc. The snap structure of the embodiment includes an I-shaped slide way and a protrusion, and the protrusion is able to extend into the I-shaped slide way and extend along the I-shaped slide way by a predetermined distance until the protrusion is snap-fitted with the I-shaped slide way, so as to complete snap-fitting and fixation. In addition to the structural form, the arrangement position and the quantity of the snap structure are also able to be adjusted as required, and the snap structure is able to be arranged on two opposite sides of a component where the snap structure is located, thereby ensuring the stability and reliability of snap-fitting.

Certainly, in addition to the foregoing snap-fit manner, other connection and fitting manners may also be used, for example, using a bolt connection, as long as a reliable connection and fixation is able to be implemented. The slide way snap allows the fixing frame 314 and the first liquid-occupying block 315 to have no undercut features on their external profiles, thereby simplifying the mold structure, facilitating processing, and reducing manufacturing cost.

In the embodiment, a wire-through region is further provided at an outer side edge of the fixing frame 314, the wire-through region passes through two sides of the fixing frame 314 along the side edge of the fixing frame 314, and the wire-through region is able to facilitate wiring, so that a wire is able to pass through the wire-through region and is provided between hard disk racks 312, thereby implementing a connection between the expansion hard disk 41 and the main board 21, and implementing an expansion effect of the hard disk.

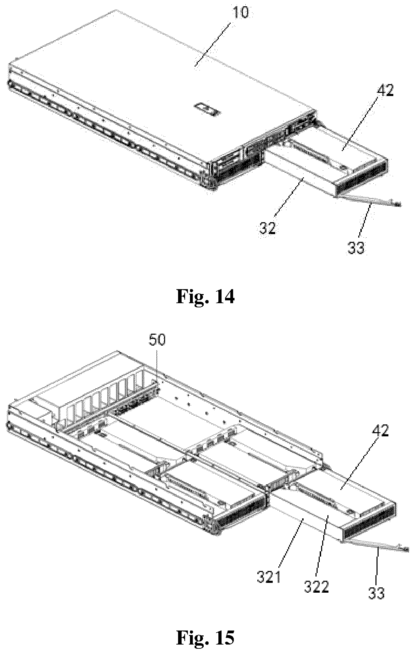

As shown in Figs. 14-16, in addition to the hard disk bracket 31, the mounting bracket 30 further includes a GPU bracket 32, the GPU bracket 32 includes a second bracket body 321, and an appearance structure of the second bracket body 321 may be the same as that of the first bracket body 311, that is, the second bracket body 321 may also adopt a drawer-type structure, so that the second bracket body 321 is movably connected to the chassis 10, and is able to extend from the first end, and a side, facing the second end, of the second bracket body 321 is also connected to the backplane 50. The second bracket body 321 is provided with a mounting position for mounting the GPU 42, so that the GPU 42 is able to be directly mounted and fixed on the second bracket body 321; and certainly, it is also able to be similar to the hard disk bracket 31, a fixing component is also able to be provided additionally, the GPU 42 is mounted in the fixing component, and the fixing component is mounted in the second bracket body 321. The GPU 42 in the second bracket body 321 may also be connected to the backplane 50 by means of components such as wires and connectors.

One or more mounting positions may be provided as required, which is similar to the arrangement of the mounting position of the expansion hard disk 41; when there are a plurality of mounting positions of the GPU 42, at least a portion of the mounting positions are arranged in a direction in which the second bracket body 321 extends from the chassis 10, that is, arranged in a length direction of the second bracket body 321, so that a plurality of GPUs 42 may be mounted in the second bracket body 321, thereby improving the utilization rate of space.

In the embodiment, the plurality of mounting positions are arranged in each second bracket body 321, and along the axis of the second bracket body 321, at least two mounting positions are located on two sides of the axis of the second bracket body 321, that is, located on the left and right sides of the length direction of the second bracket body 321. In this way, when the coolant flows along the length direction in the second bracket body 321, a portion of the coolant does not directly pass through all the GPUs 42, but only through some of the GPUs 42; the GPUs 42 that are not passed through are cooled by other portion of the coolant; such arrangement takes into account the flow direction of the coolant, the coolant exchanges heat with the previous GPUs 42 first, which causes that portion of the coolant to be heated, and in this case, when the heated coolant then passes through the subsequent GPUs 42, the heat exchange efficiency decreases; as the heat exchange continues, the heat exchange effect becomes worse towards the back, resulting in poor heat dissipation effect of a portion of GPU42. After the foregoing manner of the embodiment is adopted, the number of GPUs 42 through which each portion of the coolant passes is reduced, thereby reducing the heating degree of the coolant, and improving the heat dissipation effect of the coolant on the GPUs 42 at the rear end of the flow.

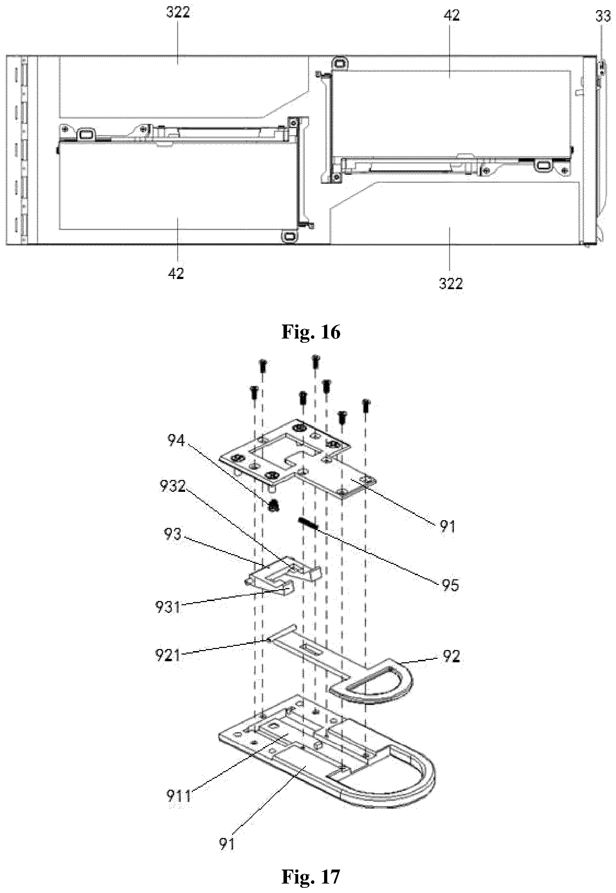

In an embodiment, the plurality of mounting positions are sequentially and alternately located on two sides of the axis of the second bracket body 321, as shown in Fig. 16. That is to say, along the length direction of the second bracket body 321, one mounting position is arranged on the left side, while the other adjacent mounting position is arranged on the right side, and so on, forming an alternating left-right arrangement. In this way, the preheating of the coolant flowing out of the former GPU 42 to the latter GPU 42 is greatly reduced, so as to improve the heat exchange efficiency.

It should be noted that, the foregoing alternating left-right arrangement may also be applied to the hard disk bracket 31, but in consideration of factors such as the size and overall heat generation of the expansion hard disk 41, the foregoing manner of the GPU bracket 32 is not used for the hard disk bracket 31 in the embodiment.

Similar to the hard disk bracket 31, the GPU bracket 32 of the embodiment further includes a second liquid-occupying block 322, and the second liquid-occupying block 322 is located on the second bracket body 321, and is arranged opposite to the mounting position, so that one side of the left side and the right side of the second bracket body 321 is a GPU 42, and the other side is the second liquid-occupying block 322, so that the GPU 42 mounted on the mounting position and the second liquid-occupying block 322 arranged opposite the GPU 42 cover the width of the second bracket body 321, thus, on the basis of the described alternating left-right arrangement, this fills the larger remaining space on the other side caused by providing components on only one side, thereby reducing the usage amount of coolant and achieving a cost-saving effect.

In order to facilitate the pull-out operation of the mounting bracket 30, in the embodiment, the operating handle 33 for pulling out the mounting bracket 30 is arranged at the end of the mounting bracket 30 located at the first end, and the operating handle 33 is exposed from the chassis 10, so that the maintenance personnel is able to operate by means of the operating handle 33 when needing to pull out the mounting bracket 30. The specific structure and arrangement of the operating handle 33 is able to be set and adjusted as required. In the embodiment, one end of the operating handle 33 is rotatably connected to the bottom of the mounting bracket 30, so that the operating handle 33 is able to be rotatably stored in the bottom of the mounting bracket 30, and is also able to be rotatably extended out of the mounting bracket 30, thereby enabling storage when not used and operation when in use.

As shown in Fig. 1, in the embodiment, the immersed liquid cooled server further includes a slide rail 80 for fitting with the slide way 101 on the inner wall of the water tank 100, and a lifting handle 90; the slide rail 80 is arranged on an outer side surface of the chassis 10; the slide rail 80 is able to be fitted with the slide rail 101 arranged on the inner wall of the water tank 100, and thus, when the hoisted server is placed into the water tank 100, the slide rail 80 is aligned with the slide way 101, and when the hoisted server is placed down, the water tank 10 is able to be stably placed at a moving position in the water tank 100 under the cooperation of the slide rail 80 and the slide way 101; furthermore, the cooperation of the slide rail 80 and the slide way 101 is also able to limit the transverse shaking of the chassis 10, thereby ensuring the stability of placing the server in the water bank 100. The lifting handle 90 is located on the outer side surface of the first end of the chassis 10; the lifting handle 90 is able to fit with an external lifting device; and the lifting device lifts the server as a whole by lifting the lifting handle 90. In addition, the lifting handle 90 is further provided with a snap 931 which is able to fit with a snap position 102 on the inner wall of the water tank 100. In this way, when the server is placed at a predetermined position within the water tank 100, causing the chassis 10 to be immersed in the water tank 100, the snap 931 is snap-fitted with the snap position 102, thereby further limiting the position of the server in the water tank 100 and ensuring the stability of the placement of the server.

In an embodiment, the buckling and releasing of the snap 931 on the lifting handle 90 are able to be achieved by means of an independent mechanism, such as providing an independent switch structure, and the adjustment of the snap-fitting relationship between the snap 931 of the lifting handle 90 and the snap position 102 is able to be achieved by toggling the switch structure. In order to further improve the convenience of use, the lifting handle 90 in the embodiment is designed such that, during lifting, when the lifting device fits with the lifting handle 90, the snap 931 on the lifting handle 90 automatically unlocks, so that the snap 931 and the snap position 102 temporarily have no snap-fit relationship therebetween, thereby allowing the chassis 10 to be placed into or lifted out the water tank.

Specifically, as shown in Figs. 17-19, the lifting handle 90 of the embodiment includes a lifting ring 91, a pull ring 92, and a snap member 93, the lifting ring 91 is the main body of the lifting handle 90, the lifting ring 91 is provided with a mounting groove 911, the lifting ring 91 may be an integral component as required, and may also be formed by assembling separate components subsequently. The lifting ring 91 is provided with a docking hole for the lifting device to extend into; the lifting device is able to extend into the docking hole to be fixedly connected to the lifting ring 91; the pull ring 92 is movable up and down relative to the lifting ring 91; a portion of the pull ring 92 is located in the mounting groove 911, and the other portion is located in the docking hole; the pull ring 92 is also provided with a through hole similar to the docking hole, so that when the lifting device passes through the through hole, the lifting device is able to drive the pull ring 92 to move upwards relative to the lifting ring 91 until the pull ring 92 moves to the top of the docking hole, and then the lifting device continues to lift to lift the entire lifting handle 90. The snap member 93 is located in the mounting groove 911 and is movably connected to the lifting ring 91; the snap member 93 is provided with a snap 931 being able to extend out of the mounting groove 911; the snap member 93 is able to be in drive fit with the pull ring 92; when the pull ring 92 is located at the lower portion of the docking hole, the snap member 93 is located at a blocking position, and in this case, the snap 931 on the snap member 93 extends out of the mounting groove 911 to be snap-fitted with the snap position 102, thereby achieving snap-fitting between the chassis 10 and the water tank 100; when the pull ring 92 is driven by the lifting device to move upwards to the top portion of the docking hole, the upward movement of the pull ring 92 drives the snap member 93 to move, so that the snap member 93 is moved to an unlocking position, and in this case, the snap 931 on the snap member 93 retracts into the mounting groove 911, eliminating the blocking relationship between the snap 931 and the snap position 102, thus releasing the snap-fit relationship between the snap 931 and the snap position 102. In this way, the snap 931 does not need to be operated separately, the snap 931 is automatically unlocked when lifting, and the snap 931 is automatically locked when not lifting, so that the whole lifting process is more convenient and faster.

A drive fit manner between the snap 93 and the pull ring 92 may be set as required, as long as the upper and lower movement of the pull ring 92 is able to be implemented to drive the snap 93 to move to make the snap 931 extend out of or retract into the mounting groove 911. In the embodiment, the snap member 93 and the lifting ring 91 are connected in a rotatable manner, more specifically, an end, away from the docking hole, of the snap member 93 is rotatably connected to the lifting ring 91, while the snap 931 is located at an end, close to the docking hole, of the snap member 93. In this way, when the snap member 93 rotates, the snap 931 is able to extend out of or retract into the mounting groove 911 Furthermore, the snap member 93 is provided with a U-shaped structure, a lower end of the pull ring 92 is able to extend into the inner side of the U-shaped structure, and a drive groove 932 is formed in the inner side wall of the U-shaped structure. Correspondingly, the pull ring 92 is provided with a drive arm 921, the drive arm 921 is located in the drive groove 932, and the inner wall surface of the drive groove 932 is obliquely provided. When the pull ring 92 moves upward, the drive arm 921 compresses the inclined inner wall of the drive groove 932, and drives the snap member 93 to rotate under the action of the inclined surface, so that the snap 931 retracts into the mounting groove 911, thereby implementing the release of the snap-fit relationship.

In the embodiment, the drive groove 932 ise arranged on the inner walls on two sides of the U-shaped structure, correspondingly, two drive arms 921 are also provided, and the two drive arms 921 are located in the two drive grooves 932 respectively, so that the pull ring 92 smoothly drives the snap member 93 to rotate.

The lifting handle 90 in the embodiment further includes a snap reset member 94 and a pull ring reset member 95; both the snap reset member 94 and the pull ring reset member 95 may be springs; the snap reset member 94 is arranged in the mounting groove 911 and abuts against the snap member 93; the snap reset member 94 provides a reset force for the snap 931 to extend out of the mounting groove 911, so that when the pull ring 92 is located at the bottom of the docking hole, under the action of the snap reset member 94, the snap member 93 automatically rotates to a position where the snap 931 extends out of the mounting groove 911, thereby ensuring the snap-fit effect. The pull ring reset member 95 is arranged in the mounting groove 911 and abuts against the pull ring 92; the pull ring reset member 95 provides the pull ring 92 with a reset force in a direction opposite to a direction in which the snap 931 is driven to retract into the mounting groove 911, that is, when not being pulled by the lifting device, the pull ring 92 is able to automatically move under the action of the pull ring reset member 95 and be retained at the bottom of the docking hole, so that the pull ring 92 does not drive the snap member 93 to the position where the snap 931 extends out. The snap reset member 94 and the pull ring reset member 95 cooperate with each other to realize the returning of the lifting handle 90 as a whole, so that when the lifting device does not lift the lifting handle 90, the snap 931 of the lifting handle 90 always extends out, thereby maintaining the cooperation with the snap position 102, and after the lifting device releases the pull ring 92 after the lifting is completed, the pull ring 92 and the snap 93 are reset respectively, thereby achieving the automatic snap-fitting between the snap 931 and the snap position 102.

It should be noted that, "a plurality of" in the foregoing embodiment refers to at least two.

From the above description, it is determined that the above embodiments of the present invention achieve the following technical effects:
1. the problem in the related art that the inspection and maintenance of an immersion server are time-consuming and inefficient is solved;
2. there is no need to hoist the entire server out of the water tank, significantly reducing the difficulty and complexity of maintenance, and decreasing the frequency of using lifting device to lift the entire server out of the water tank, thereby simplifying the maintenance process;
3. when the basic component is inspected and repaired, the plug-and-play basic component is able to be pulled out for inspection and repairing, and when the expansion component is inspected and repaired, the mounting bracket is able to be pulled out, thereby allowing for convenient replacement of the expansion components, so as to meet different usage needs;
4. the number of expansion hard disks and GPUs that is able to be arranged in the mounting bracket is increased, which facilitates increasing the number of components supported in a single node in a limited space;
5. the vacant space is occupied, so that the amount of the fluorinated liquid to be filled in the chassis is reduced, thereby reducing the usage of the fluorinated liquid to achieve the effect of reducing costs, and providing the function of flow guidance;
6. the lifting handle facilitate lifting of the chassis by the lifting device, and furthermore, a guiding structure and an automatic locking structure are provided to facilitate lifting.

Apparently, the described embodiments are merely a part rather than all of the embodiments of the present invention. All other embodiments obtained by a person of ordinary skill in the art based on the embodiments of the present invention without any inventive effort shall all fall within the scope of protection of the present invention.

The content above merely relates to preferred embodiments of the present invention and is not intended to limit the present invention. For a person skilled in the art, the present invention may have various modifications and variations. Any modifications, equivalent replacements, improvements, etc. made within the principle of the present invention shall all belong to the scope of protection of the present invention.

## Claims

1. An immersed liquid cooled server, comprising:
a chassis (10), wherein the chassis (10) is provided with a first end and a second end opposite to the first end, in response to an immersion of the chassis (10) in a water tank (100), the first end is located on an opening side of the water tank (100), the chassis (10) is provided with a first region and a second region, and in response to the chassis (10) being taken out of the water tank (100) and placed horizontally, the first region and the second region are separated and stacked vertically;
a basic component (20) for maintaining an operation of the server, wherein the basic component (20) is located in the first region, at least a portion of the basic component (20) is detachably arranged at the first end and exposed from the chassis (10), and the basic component (20) comprises a main board (21), a network card (22), an interface and a hard disk; and
a mounting bracket (30), wherein the mounting bracket (30) is movably arranged in the second region of the chassis (10) and is able to extend out of the chassis (10) from the first end, the mounting bracket (30) is provided with a mounting position for mounting an expansion component.

2. The immersed liquid cooled server as claimed in claim 1, wherein the interface comprises an Input/Output (IO) interface (23); the hard disk comprises a hot-plug hard disk (25); the basic component (20) further comprises an Open Compute Project (OCP) network card (24); and the network card (22), the IO interface (23), the OCP network card (24) and the hot-plug hard disk (25) are detachably arranged at the first end, and are exposed from the chassis (10).

3. The immersed liquid cooled server as claimed in claim 1, wherein the expansion component comprises at least one of an expansion hard disk (41) and a Graphics Processing Unit (GPU) (42).

4. The immersed liquid cooled server as claimed in claim 1, wherein the immersed liquid cooled server further comprises a backplane (50), the backplane (50) is located at the second end, one side of the backplane (50) is provided with a connector for connecting to components in the first region, and the other side of the backplane (50) is provided with an expansion interface for connecting to components in the second region.

5. The immersed liquid cooled server as claimed in claim 1, wherein the immersed liquid cooled server further comprises a power supply clamp (60), the power supply clamp (60) is arranged in the chassis (10) and is located at the second end, and in response to the immersion of the chassis (10) in the water tank (100), the power supply clamp (60) contacts a contact at a bottom of the water tank (100), and an external power supply supplies power to the immersed liquid cooled server.

6. The immersed liquid cooled server as claimed in claim 1, wherein the immersed liquid cooled server further comprises a space-occupying and flow-guidance block (70), the space-occupying and flow-guidance block (70) is arranged in the chassis (10) and located at the second end, and the space-occupying and flow-guidance block (70) is provided with a channel for guiding a coolant.

7. The immersed liquid cooled server as claimed in any one of claims 1 to 6, wherein one or more mounting brackets (30) are provided, and in response to a plurality of mounting brackets (30), the plurality of mounting brackets (30) are arranged along a length direction of the first end.

8. The immersed liquid cooled server as claimed in claim 7, wherein the plurality of mounting brackets (30) are provided, and all of the plurality of mounting brackets (30) comprise at least one of a hard disk bracket (31) and a Graphics Processing Unit (GPU) bracket (32).

9. The immersed liquid cooled server as claimed in any one of claims 1 to 6, wherein the mounting bracket (30) comprises a hard disk bracket (31), and the hard disk bracket (31) comprises:
a first bracket body (311), wherein the first bracket body (311) is provided with a mounting region, the first bracket body (311) is movably connected to the chassis (10) and is able to extend out from the first end; and
a hard disk rack (312), wherein the hard disk rack (312) is arranged in the mounting region, the hard disk rack (312) is provided with the mounting position for mounting an expansion hard disk (41), and in response to the first bracket body (311) extending from the chassis (10), the hard disk rack (312) is exposed from the chassis (10).

10. The immersed liquid cooled server as claimed in claim 9, wherein a plurality of hard disk racks (312) are provided, and at least a portion of the plurality of hard disk racks (312) are arranged along a direction in which the first bracket body (311) extends from the chassis (10).

11. The immersed liquid cooled server as claimed in claim 10, wherein the hard disk rack (312) is provided with a first side and a second side that are arranged opposite to each other; the first side is closer to the first end than the second side; the second side of at least one of the plurality of hard disk brackets (312) is rotatably connected to the first bracket body (311); and in response to the first bracket body (311) extending from the chassis (10), the hard disk rack (312) is able to rotate and lift the first side by a predetermined distance.

12. The immersed liquid cooled server as claimed in claim 11, wherein the hard disk bracket (31) further comprises a handle (313), the handle (313) is rotatably arranged on a side, between the first side and the second side, of the hard disk bracket (312), and in response to a rotation of the handle (313), an end of the handle (313) abuts against the first bracket body (311), and supports the hard disk bracket (312) to be in an inclined state.

13. The immersed liquid cooled server as claimed in claim 9, wherein the hard disk bracket (31) further comprises:
a fixing frame (314), wherein the fixing frame (314) is arranged in the mounting region and located on a peripheral side of the hard disk rack (312); and
a first liquid-occupying block (315), wherein the fixing frame (314) is provided with a cavity, the first liquid-occupying block (315) is arranged in the cavity, and the first liquid-occupying block (315) and the fixing frame (314) are snap-fitted with each other; and/or the fixing frame (314) and the first bracket body (311) are snap-fitted with each other.

14. The immersed liquid cooled server as claimed in any one of claims 1 to 6, wherein the mounting bracket (30) comprises a GPU bracket (32), and the GPU bracket (32) comprises a second bracket body (321), the second bracket body (321) is movably connected to the chassis (10) and is able to extend out from the first end; the second bracket body (321) is provided with the mounting position for mounting a GPU (42); one or more mounting positions are provided; and in response to a plurality of mounting positions being provided, at least a portion of the plurality of the mounting positions are arranged along a direction in which the second bracket body (321) extends from the chassis (10).

15. The immersed liquid cooled server as claimed in claim 14, wherein the plurality of mounting positions are provided, and along an axis of the second bracket body (321), at least two of the plurality of mounting positions are located on two sides of the axis of the second bracket body (321).

16. The immersed liquid cooled server as claimed in claim 15, wherein the plurality of mounting positions are sequentially and alternately located on two sides of the axis of the second bracket body (321).

17. The immersed liquid cooled server as claimed in claim 14, wherein the GPU bracket (32) further comprises a second liquid-occupying block (322), the second liquid-occupying block (322) is located on the second bracket body (321) and is arranged opposite to the mounting position, so that the GPU (42) mounted on the mounting position and the oppositely arranged second liquid-occupying block (322) cover a width of the second bracket body (321).

18. The immersed liquid cooled server as claimed in any one of claims 1 to 6, wherein an end, located at the first end, of the mounting bracket (30) is provided with an operating handle (33) for pulling out the mounting bracket (30).

19. The immersed liquid cooled server as claimed in any one of claims 1 to 6, wherein the immersed liquid cooled server further comprises:
a slide rail (80) for fitting with a slide way (101) of an inner wall of the water tank (100), wherein the slide rail (80) is arranged on an outer side surface of the chassis (10); and
a lifting handle (90), wherein the lifting handle (90) is located on an outer side surface of the first end of the chassis (10), the lifting handle (90) is provided with a snap (931) for fitting with a snap position (102) of an inner wall of the water tank (100), and in response to the immersion of the chassis (10) in the water tank (100), the snap (931) is snap-fitted with the snap position (102).

20. The immersed liquid cooled server as claimed in claim 19, wherein the lifting handle (90) comprises:
a lifting ring (91), wherein the lifting ring (91) is provided with a mounting groove (911);
a pull ring (92), wherein the pull ring (92) is movably arranged relative to the lifting ring (91), at least a portion of the pull ring (92) is located in the mounting groove (911); and
a snap member (93), wherein the snap member (93) is located in the mounting groove (911) and rotatably connected to the lifting ring (91), the snap member (93) is provided with the snap (931) being able to extend out of the mounting groove (911); the snap member (93) is provided with a drive groove (932); the pull ring (92) is provided with a drive arm (921); the drive arm (921) is located in the drive groove (932); and in response to a move of the pull ring (92), the drive arm (921) presses against the inner wall of the drive groove (932), and drives the snap member (93) to rotate, so that the snap (931) retracts into the mounting groove (911).

21. The immersed liquid cooled server as claimed in claim 20, wherein the lifting handle (90) further comprises:
a snap reset member (94), wherein the snap reset member (94) is arranged in the mounting groove (911) and abuts against the snap member (93), the snap reset member (94) provides a reset force for the snap member (931) to extend out of the mounting groove (911); and
a pull-ring reset member (95), wherein the pull-ring reset member (95) is arranged in the mounting groove (911) and abuts against the pull ring (92), the pull-ring reset member (95) provides a reset force for the pull ring (92) in an opposite direction of a movement that retracts the snap (931) into the mounting groove (911).

22. The immersed liquid cooled server as claimed in claim 1, wherein the network card (22), the interface, and the hard disk are exposed from the chassis (10), and personnel is able to directly perform inspection and maintenance on components of the first end through the opening side.
